(19) Europäisches Patentamt
European Patent Office
Office européen des brevets

(11) **EP 3 347 980 B1**

(12) **EUROPEAN PATENT SPECIFICATION**

(45) Date of publication and mention
of the grant of the patent:
**22.05.2024 Bulletin 2024/21**

(21) Application number: **15770554.2**

(22) Date of filing: **11.09.2015**

(51) International Patent Classification (IPC):
**H02P 9/30** (2006.01)          **H02P 9/10** (2006.01)
**G01R 23/02** (2006.01)

(52) Cooperative Patent Classification (CPC):
**H02P 9/302; H02P 9/10;** G01R 23/02

(86) International application number:
**PCT/FI2015/050598**

(87) International publication number:
**WO 2016/034777 (10.03.2016 Gazette 2016/10)**

(54) **METHOD FOR CONTROLLING GENERATOR VOLTAGE**

VERFAHREN ZUR STEUERUNG EINER GENERATORSPANNUNG

PROCÉDÉ POUR COMMANDER UNE TENSION DE GÉNÉRATEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.07.2018 Bulletin 2018/29**

(73) Proprietor: **Wärtsilä Finland Oy
65100 Vaasa (FI)**

(72) Inventors:
• **KAAS, Tom
65410 Solf (FI)**

• **SAIKKONEN, Ari
65200 Vaasa (FI)**

(74) Representative: **Väänänen, Janne Kalervo et al
Vanarix Oy
Laaksolahdentie 74
02730 Espoo (FI)**

(56) References cited:
**DE-A1-102008 043 203     US-A- 4 788 653**

**Description**

**Field of the disclosure**

The disclosure relates generally to an electrical power system comprising one or more synchronous generators. More particularly, the disclosure relates to a method for controlling the excitation of a synchronous generator, and to a voltage regulator for controlling the excitation of a synchronous generator. Furthermore, the disclosure relates to a computer program for configuring a voltage regulator of an electrical power system.

**Background**

In many cases, an electrical power system for producing electrical energy comprises one or more prime movers arranged to rotate one or more synchronous generators. Each prime mover can be for example a turbine or a piston engine such as a diesel engine. For each synchronous generator, the electrical power system comprises an excitation device configured to supply excitation current to the rotor winding of the synchronous generator under consideration. The excitation device can be for example a contactless rotating exciter or a slip-ring exciter. A control system of each synchronous generator comprises a voltage regulator for controlling the excitation device. The voltage regulator is often called an automatic voltage regulator "AVR". The voltage regulator is a part of a voltage control loop for controlling the excitation of the synchronous generator on the basis of actual and reference values of the amplitude of the generator voltage.

A control system of a synchronous generator may further comprise a power system stabilizer "PSS" in parallel with the voltage regulator in order to enhance the dynamic stability of the electrical power system. Power system stabilizers have been shown to be effective in damping oscillations where instantaneous powers of synchronous generators or groups of synchronous generators oscillate with respect to each other. The frequency area of these oscillations can be e.g. from 0.3 Hz to 2 Hz. A power system stabilizer comprises typically a lead-lag circuit for modifying a signal indicative of deviation from synchronous operation, e.g. a signal indicative of deviation of a measured rotation speed from the nominal rotational speed. The lead-lag circuitry provides a phase-lead at the frequency area of the above-mentioned oscillations, and thus the lead-lag circuitry provides a good phase-margin on this frequency area. Therefore, the power system stabilizer "PSS" can be tuned to effectively suppress the above-mentioned oscillations.

A control system of the kind described above is, however, not free from challenges. One of the challenges is that the power system stabilizer "PSS" may have an inverse effect on the damping of torsional mode oscillations that may occur in a rotating system comprising the rotor of a synchronous generator and a rotating part of a turbine or another prime mover. In a case where the prime mover is a four-stroke piston engine, the lowest frequency component that is excited due to the nature of the engine is the half rotation frequency that is $N/(2 \times 60)$, where N is the rotational speed as revolutions per minute. Another frequency that can be harmful is the lowest natural torsion oscillation frequency. This natural frequency can be estimated by modelling the combination of the rotor of the synchronous generator and the rotating part of the prime mover as a two mass system comprising a flexible coupling. In this model, the above-mentioned natural frequency is:

$$\frac{1}{2\pi} \sqrt{K_c \left( \frac{J_M + J_G}{J_M J_G} \right)} , \qquad (1)$$

where Kc is the torsional elastic constant of the flexible coupling, $J_G$ is the moment of inertia of the rotor of the synchronous generator, and $J_M$ is the moment of inertia of the rotating part of the prime mover.

Publications US4080559 and US4788653 describe control systems where a power system stabilizer "PSS" comprises a band-rejection filter. The stop-band of the band-rejection filter is arranged to cover the frequency area of the torsional mode oscillations. The band-rejection filter suppresses the frequency components related to the torsional mode oscillations, and therefore the adverse phenomenon where the power system stabilizer maintains or even amplifies the torsional mode oscillations can be avoided.

In conjunction with many electrical power systems, there is however still a need for techniques for controlling the excitation of synchronous generators so that the torsional mode oscillations are kept at a sufficiently low level. This need is present especially in electrical power systems of ships and in other small electrical power systems where load variations can be strong relative to the nominal power of the electrical power system.

Publication DE102008043203 describes a filter mechanism for filtering a generator output signal and exhibiting a pre-set filter characteristic e.g. band pass characteristic, with a cut-off frequency. A detection mechanism detects a frequency of the filtered output signal. An adaptation mechanism adapts the cut-off frequency of the filter mechanism depending on the detected frequency.

**Summary**

The present invention is defined in the independent claims 1,4 and 15.

**Brief description of the figures**

Exemplifying and non-limiting embodiments of the invention and their advantages are explained in greater detail below in the sense of examples and with reference to the accompanying drawings, in which:

figure 1a illustrates an electrical power system according to an exemplifying and non-limiting embodiment of the invention,

figure 1b shows exemplifying signal waveforms appearing in the voltage control loop of the electrical power system illustrated in figure 1a,

figure 2 illustrates an electrical power system according to an exemplifying and non-limiting embodiment of the invention,

figure 3 illustrates an electrical power system according to an exemplifying and non-limiting embodiment of the invention,

figure 4 illustrates a voltage regulator according to an exemplifying and non-limiting embodiment of the invention, and

figure 5 is a flowchart of a method according to an exemplifying and non-limiting embodiment of the invention for controlling the excitation of a synchronous generator.

**Description of exemplifying and non-limiting embodiments**

The specific examples provided in the description below should not be construed as limiting the scope and/or the applicability of the accompanied claims. Lists and groups of examples provided in the description are not exhaustive unless otherwise explicitly stated.

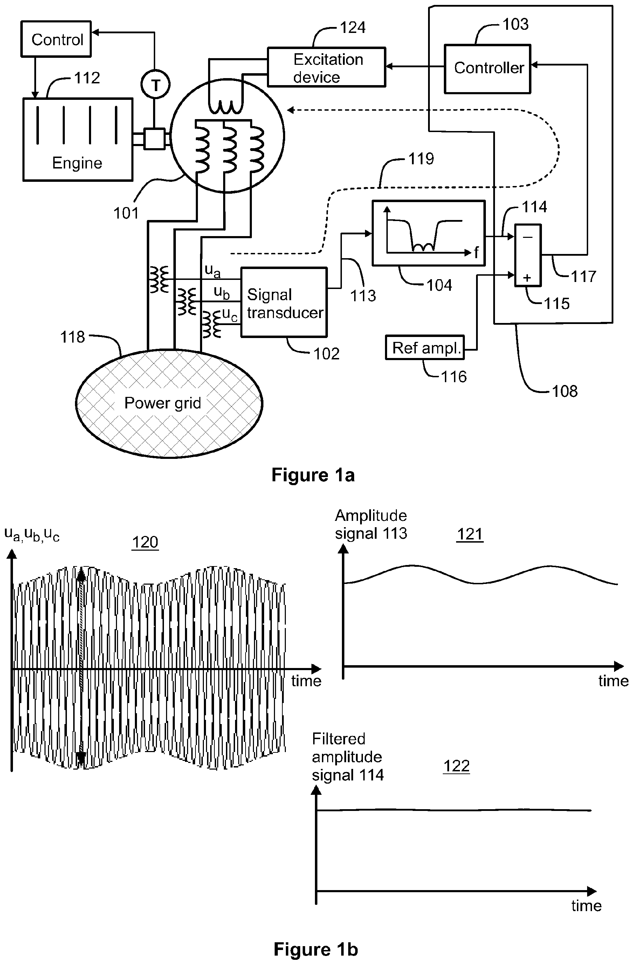

Figure 1a illustrates an electrical power system according to an exemplifying and non-limiting embodiment of the invention. The electrical power system can be, for example but not necessarily, an electrical power system of a ship or a diesel power plant. The electrical power system comprises a synchronous generator 101 that is driven by a prime mover 112. The synchronous generator 101 is configured to supply electrical power to a power grid 118. The prime mover 112 can be for example a diesel engine. An excitation device 124 is configured to supply excitation current to the rotor winding of the synchronous generator 101. The excitation device 124 can be for example a contactless rotating exciter or a slip-ring exciter.

The electrical power system comprises a signal transducer 102 for producing an amplitude signal 113 indicative of the amplitude of the three-phase stator voltage of the synchronous generator 101. The amplitude signal 113 can be for example the length, i.e. the norm, of a space vector of the three-phase stator voltage. In this exemplifying case, the amplitude signal 113 is substantially:

$$\frac{2}{3}\text{abs}(u_a + \mathbf{a}u_b + \mathbf{a}^2 u_c), \qquad (2)$$

where $u_a$, $u_b$, and $u_c$ are instantaneous values of the stator phase voltages of the synchronous generator 101, a is a complex number (-1 + iV3)/2, and "abs" means the absolute value. Exemplifying waveforms of the stator phase voltages $u_a$, $u_b$, and $u_c$ are presented in figure element 120 in figure 1b, and the corresponding waveform of the amplitude signal 113 is presented in figure element 121 in figure 1b.

The electrical power system comprises a band-rejection filter 104 having a stop-band that covers at least partly a frequency area of torsional mode oscillations that may take place in a rotating system that comprises the rotor of the synchronous generator 101 and a rotating part of the prime mover 112. The lower corner frequency of the above-mentioned stop-band can be for example on the range from 30 % to 70 % of $f_s/2p$ and the upper corner frequency of the stop-band can be on the range from 80 % to 150 % of the $f_s/2p$, where $f_s$ is the nominal frequency of the voltage of the synchronous generator, typically 50 Hz or 60 Hz, and p is the number of pole pairs of the synchronous generator. Thus, $f_s/2p$ is the nominal half rotation frequency of the synchronous generator. The corner frequencies may represent e.g. a 3 dB suppression level. The band-rejection filter 104 is configured to output a filtered amplitude signal 114, and a subtraction element 115 is configured to form a difference 117 between the reference amplitude 116 of the generator voltage and the filtered amplitude signal 114. The filtered amplitude signal 114 is illustrated in figure element 122 in figure 1b. In the exemplifying situation presented in figure 1b, the filtered amplitude signal 114 is substantially constant.

The electrical power system comprises a controller 103 for controlling the excitation device 124 on the basis of the above-mentioned difference 117. The controller 103 can be configured to carry out for example proportional P control, proportional and integrative PI control, proportional, integrative, and derivative PID control, or some other suitable control functionality. As can be seen from figure 1a, the signal transducer 102, the band-rejection filter 104, and the controller 103 are parts of a voltage control loop for controlling the excitation of the synchronous generator 101 on the basis of the amplitude signal 113 and the reference amplitude 116. In figure 1a, the voltage control loop is illustrated with the aid of a dashed curve 119. As the voltage control loop comprises the band-rejection filter 104, frequency components related to the torsional mode oscillations are suppressed in the voltage control loop and therefore adverse phenomena where the voltage control loop maintains or even amplifies the torsional mode oscillations can be avoided.

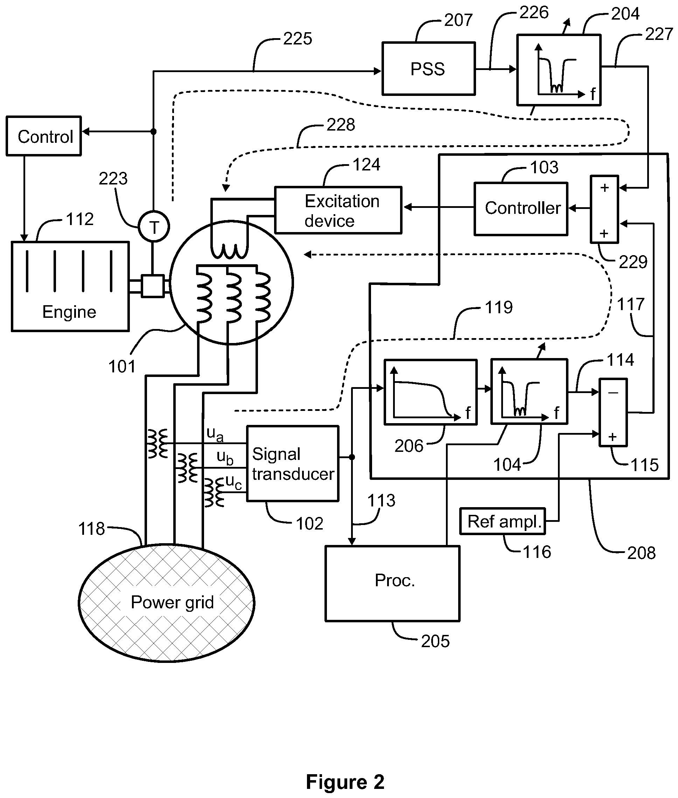

Figure 2 illustrates an electrical power system according to an exemplifying and non-limiting embodiment of the invention. The electrical power system comprises a synchronous generator 101, a signal transducer 102 for producing an amplitude signal 113 indicative of the amplitude of the voltage of the synchronous generator, and a controller 103 for controlling an excitation device 124 connected to the synchronous generator. The signal transducer 102 and the controller 103 are parts of a voltage control loop 119 for controlling the excitation of the synchronous generator on the basis of the amplitude signal 113 and the reference amplitude 116 of the generator voltage. The voltage control loop 119 further comprises a band-rejection filter 104. The stop-band of the band-rejection filter covers at least partly the frequency area of torsional mode oscillations of a rotating system comprising the rotor of the synchronous generator 101 and a rotating part of a prime mover 112. In the exemplifying electrical power system illustrated in figure 2, the voltage control loop further comprises a low-pass filter 206 for damping high-frequency signal components from the amplitude signal 113 and thereby high-frequency amplitude oscillations from the voltage of the synchronous generator 101.

The exemplifying electrical power system illustrated in figure 2 comprises a power system stabilizer "PSS" 207 that receives a speed signal 225 from a speed sensor 223. The speed signal 225 is indicative of a measured rotational speed of the synchronous generator 101. The power system stabilizer 207 comprises typically a lead-lag circuitry for providing a phase-lead at a frequency area where the power system stabilizer is capable of damping oscillations. The power system stabilizer 207 is configured to form a stabilizing signal 226 on the basis of deviation of the measured rotational speed from the nominal rotational speed. At least a part of the information contained by the stabilizing signal 226 is conducted to the controller 103 via a summation element 229. As can be seen from figure 2, the power system stabilizer 207 and the controller 103 are parts of a stabilizing control loop for controlling the excitation of the synchronous generator 101 on the basis of the deviation of the measured rotational speed from the nominal rotational speed. In figure 2, the stabilizing control loop is illustrated with a dashed curve 228.

In the exemplifying electrical power system illustrated in figure 2, the stabilizing control loop 228 further comprises a band-rejection filter 204 having a stop-band covering at least partly the frequency area of the torsional mode oscillations of the rotating system. The band-rejection filter 204 suppresses the frequency components related to the torsional mode oscillations, and therefore the adverse phenomenon where the power system stabilizer 207 maintains or even amplifies the torsional mode oscillations can be avoided.

In the exemplifying electrical power system illustrated in figure 2, the band-rejection filter 104 comprises one or more controllable components for implementing a changeable frequency response. Thus, the frequency response of the band-rejection filter 104 can be tuned to be suitable for different generator-prime mover combinations which may have different torsional oscillation characteristics. The electrical power system may further comprise a processing system 205 for computing the frequency spectrum of the amplitude signal 113 and for setting the band-rejection filter 104 to suppress one or more peaks belonging to a pre-determined frequency band of the computed frequency spectrum. The band-rejection filter 104 can be for example a digital filter that is capable of forming one or more changeable transmission zeros. The processing system 205 can be configured to set the band-rejection filter 104 to form the one or more changeable transmission zeros at one or more frequencies corresponding to the one or more peaks of the computed frequency spectrum. The frequency spectrum can be computed using a digital Fourier transform, e.g. the fast Fourier transform "FFT". Also the band-rejection filter 204 can be a controllable filter and the band-rejection filter 204 can be controlled in the same way as the band-rejection filter 104.

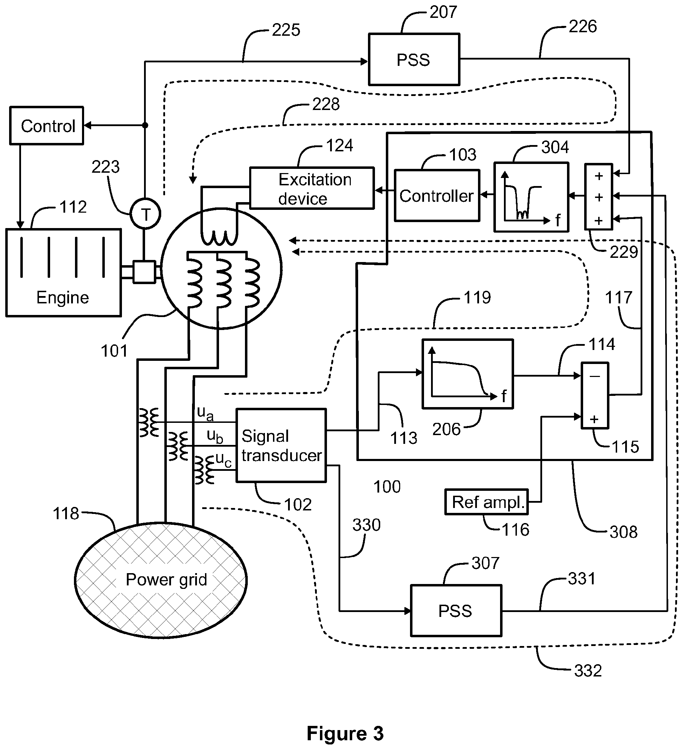

Figure 3 illustrates an electrical power system according to an exemplifying and non-limiting embodiment of the invention. The electrical power system comprises a synchronous generator 101, a signal transducer 102 for producing an amplitude signal 113 indicative of the amplitude of the voltage of the synchronous generator, and a controller 103 for controlling an excitation device 124 connected to the synchronous generator. The signal transducer 102 and the controller 103 are parts of a voltage control loop 119 for controlling the excitation of the synchronous generator on the basis of the amplitude signal 113 and the reference amplitude 116. The voltage control loop further comprises a band-rejection filter 304. The stop-band of the band-rejection filter covers at least partly the frequency area of torsional mode oscillations of a rotating system comprising the rotor of the synchronous generator 101 and a rotating part of a prime mover 112. In the exemplifying electrical power system illustrated in figure 3, the voltage control loop further comprises a low-pass filter 206 for damping high-frequency signal components from the amplitude signal 113 and thereby high-frequency amplitude oscillations from the voltage of the synchronous generator 101.

The exemplifying electrical power system illustrated in figure 3 comprises a first power system stabilizer "PSS" 207 that receives a speed signal 225 from a speed sensor 223 and a second power system stabilizer "PSS" 307 that receives a frequency signal 330 from the signal transducer 102. The speed signal 225 is indicative of the measured rotational speed of the synchronous generator 101 and the frequency signal 330 is indicative of a measured frequency of the three-phase voltage of the synchronous generator 101. In this exemplifying case, the signal transducer 102 is configured to produce, in addition to the amplitude signal 113, the frequency signal 330. The frequency can be measured for example based on the rotational speed of the space vector of the three-phase voltage. Each of the power system stabilizers 207 and 307 comprises typically a lead-lag circuitry for providing a phase-lead at a frequency area where the power system stabilizer under consideration is capable of damping oscillations. The power system stabilizer 207 is configured to form a first stabilizing signal 226 on the basis of deviation of the measured rotational speed from the nominal rotational speed, and the power system stabilizer 307 is configured to form a second stabilizing signal 331 on the basis of deviation of the measured frequency from the nominal frequency. The stabilizing signals 226 and 331 and a difference signal 117 related to the voltage control loop are supplied to a summation element 229. As can be seen from figure 3, the power system stabilizer 207 and the controller 103 are parts of a first stabilizing control loop for controlling the excitation of the synchronous generator 101 on the basis of the deviation of the measured rotational speed from the nominal rotational speed, and the power system stabilizer 307 and the controller 103 are parts of a second stabilizing control loop for controlling the excitation on the basis of the deviation of the measured frequency from the nominal frequency. In figure 3, the first stabilizing control loop is illustrated with a dashed curve 228 and the second stabilizing control loop is illustrated with a dashed curve 332.

In the exemplifying electrical power system illustrated in figure 3, the band-rejection filter 304 is between the summation element 229 and the controller 103. Therefore, the same band-rejection filter 304 is used both in the voltage control loop 119 and in the stabilizing control loops 228 and 332 for suppressing the frequency components related to the torsional oscillations. In cases where the band-rejection filter 304 is a linear filter, the single filter arrangement shown in figure 3 operates in the same way as an arrangement where there are three separate band-rejection filters in the voltage control loop and in the stabilizing control loops in front of the summation element 229. If also the controller 103 is a linear element, the band-rejection filter 304 could be, in principle, after the controller.

As presented in publication US4733156, the first power system stabilizer 207 can be tuned to increase the synchronizing torque of the synchronous generator 101 and the second power system stabilizer 307 can be configured to increase the braking torque of the synchronous generator 101. The synchronizing torque and the braking torque are illustrated by the following differential equation concerning the deviation of the power angle $\Delta\delta$ of the synchronous generator:

$$M\ d^2\Delta\delta/dt^2 + D\ d\Delta\delta/dt + K\ \Delta\delta = \Delta T \qquad\qquad (3)$$

where M is related to the moment of inertia of the rotating system, D represents the above-mentioned braking torque, K represents the above-mentioned synchronizing torque, and $\Delta T$ represents fluctuation of the torque generated by the prime mover 112. The braking and synchronizing torques D and K are dependent on the properties of the synchronous generator, on the operating point of the synchronous generator, and on parameters of the voltage control loop and of the stabilizing control loops.

Practical implementations of electrical power systems of the kind described above comprise typically a voltage regulator that is often called an automatic voltage regulator "AVR". The above-mentioned band-rejection filter can be a part of the voltage regulator or the band-rejection filter can be an external element that is connected to the voltage regulator. Figure 1a illustrates an exemplifying case where the band-rejection filter 104 is not a part of a voltage regulator 108. Figure 2 illustrates an exemplifying case where the band-rejection filter 104 and the low-pass filter 206 are parts of a voltage regulator 208. Figure 3 illustrates an exemplifying case where the band-rejection filter 304 and the low-pass filter 206 are parts of a voltage regulator 308 but the band-rejection filter is located in a different way than in the exemplifying case illustrated in figure 2. It is also possible that the signal transducer 102 is a part of a voltage regulator.

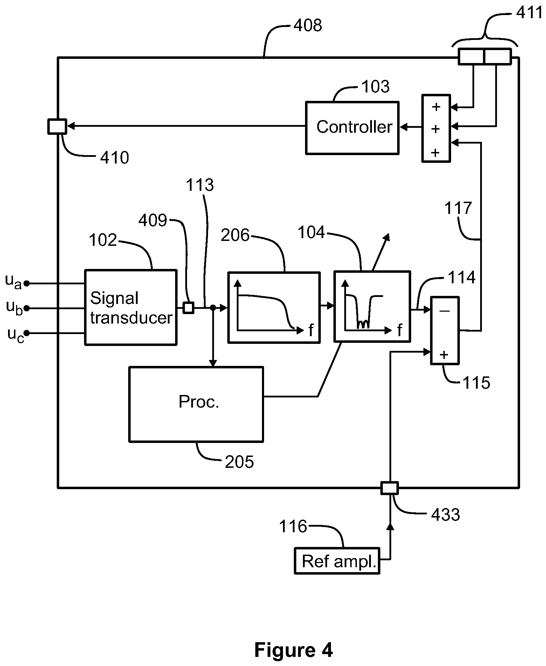

Figure 4 illustrates a voltage regulator 408 according to an exemplifying and non-limiting embodiment of the invention. The voltage regulator comprises a first signal interface 409 for receiving an amplitude signal 113 that is indicative of the amplitude of the voltage of a synchronous generator. In this exemplifying case, the voltage regulator comprises a signal transducer 102 for producing the amplitude signal 113 and thus the first signal interface 409 is an internal signal interface. It is, however, also possible that the voltage regulator does not comprise a signal transducer of the kind mentioned above and, in this case, the amplitude signal 113 is received from outside the voltage regulator. The voltage regulator comprises a second signal interface 410 for connecting to an excitation device connected to the synchronous generator. The voltage regulator comprises a controller 103 for constituting a part of a voltage control loop for controlling the excitation of the synchronous generator on the basis of the amplitude signal 113 and the reference amplitude 116 of the voltage. The reference amplitude 116 is received at a data interface 433. The voltage regulator comprises a band-rejection filter 104 for constituting another part of the above-mentioned voltage control loop. The lower corner frequency of the stop-band of the band-rejection filter 104 can be on the range from 30 % to 70 % of $f_s/2p$ and the upper corner frequency of the stop-band can be on the range from 80 % to 150 % of the $f_s/2p$, where $f_s$ is the nominal frequency of the voltage of the synchronous generator, e.g. 50 Hz or 60 Hz, and p is a positive integer that represents the number of pole pairs of the synchronous generator. Thus, $f_s/2p$ is the nominal half rotation frequency of the synchronous generator.

In a voltage regulator according to an exemplifying and non-limiting embodiment of the invention, the band-rejection filter 104 comprises one or more controllable components for implementing a changeable frequency response.

A voltage regulator according to an exemplifying and non-limiting embodiment of the invention further comprises a processing system 205 for computing a frequency spectrum of the amplitude signal 113 and for setting the band-rejection filter 104 to suppress one or more peaks belonging to a pre-determined frequency band of the frequency spectrum.

In a voltage regulator according to an exemplifying and non-limiting embodiment of the invention:

- the one or more controllable elements of the band-rejection filter 104 are suitable for forming one or more changeable transmission zeros on the frequency response of the band-rejection filter, and

- the processing system 205 is configured to set the band-rejection filter 104 to form the one or more changeable transmission zeros at one or more frequencies corresponding to the one or more peaks of the frequency spectrum.

A voltage regulator according to an exemplifying and non-limiting embodiment of the invention further comprises a low-pass filter 206 for constituting a part of the voltage control loop.

A voltage regulator according to an exemplifying and non-limiting embodiment of the invention further comprises one or more third signal interfaces 411 for receiving one or more stabilizer signals produced by one or more power system stabilizers "PSS". In a case where the one or more stabilizer signals are received at the one or more third signal interfaces 411, the controller 103 is a part of the one or more stabilizing control loops each comprising one of the power system stabilizers.

The implementation of signal processing elements, such as the band-rejection filter and the controller, can be based on one or more analogue circuits, one or more digital signal processing "DSP" circuits, or a combination thereof. Each digital signal processing circuit as well as the processing system 205 shown in figures 2 and 4 can be implemented with one or more processor circuits, each of which can be a programmable processor circuit provided with appropriate software, a dedicated hardware processor such as, for example, an application specific integrated circuit "ASIC", or a configurable hardware processor such as, for example, a field programmable gate array "FPGA".

A computer program according to an exemplifying and non-limiting embodiment of the invention comprises computer executable instructions for configuring a programmable digital signal processing "DSP" circuit of a voltage regulator to constitute a band-rejection filter which is a part of a voltage control loop for controlling the excitation of a synchronous generator on the basis of an amplitude signal and the reference amplitude, where the amplitude signal is indicative of the amplitude of generator voltage.

The above-mentioned executable instructions can be e.g. subroutines or functions implemented with a suitable programming language.

A computer program product according to an exemplifying and non-limiting embodiment of the invention comprises a non-transitory computer readable medium, e.g. a compact disc "CD", encoded with a computer program according to an exemplifying embodiment of invention.

A data signal according to an exemplifying and non-limiting embodiment of the invention is encoded to carry information defining a computer program according to an exemplifying embodiment of invention.

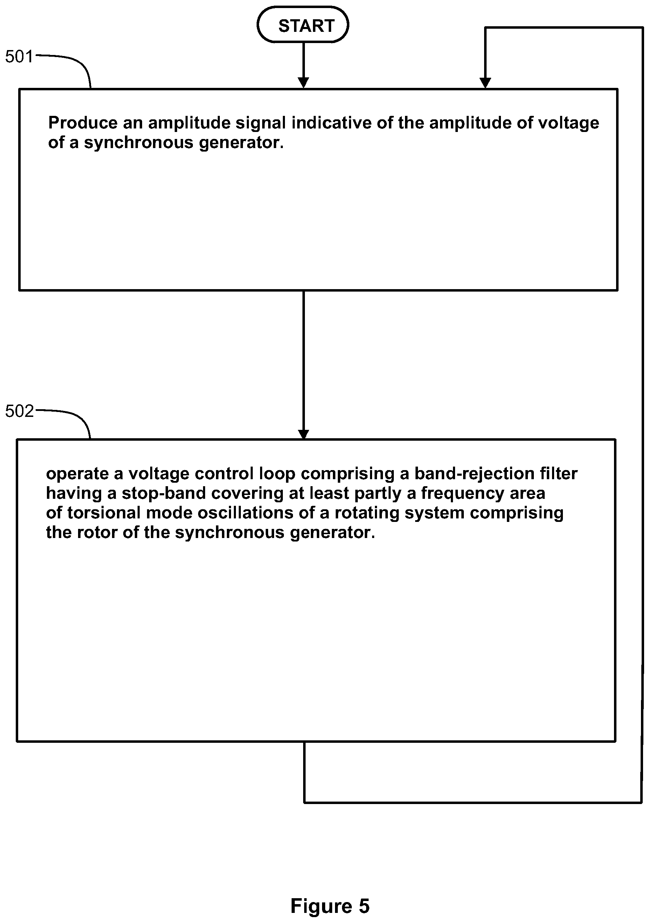

Figure 5 is a flowchart of a method according to an exemplifying and non-limiting embodiment of the invention for controlling the excitation of a synchronous generator. The method comprises the following actions:

- action 501: producing an amplitude signal indicative of the amplitude of the voltage of the synchronous generator, and

- action 502: operating a voltage control loop for controlling the excitation of the synchronous generator on the basis of the amplitude signal and the reference amplitude of the voltage, where the voltage control loop comprises a band-rejection filter having a stop-band covering at least partly a frequency area of torsional mode oscillations of a rotating system comprising, inter alia, the rotor of the synchronous generator.

In a method according to an exemplifying and non-limiting embodiment of the invention, the lower corner frequency of the stop-band of the band-rejection filter is on the range from 30 % to 70 % of $f_s/2p$ and the upper corner frequency of the stop-band of the band-rejection filter is on a range from 80 % to 150 % of the $f_s/2p$, where $f_s$ is the nominal frequency of the voltage of the synchronous generator and p is the number of pole pairs of the synchronous generator.

A method according to an exemplifying and non-limiting embodiment of the invention comprises tuning the band-rejection filter by changing settings of one or more controllable components of the band-rejection filter.

A method according to an exemplifying and non-limiting embodiment of the invention further comprises computing the frequency spectrum of the amplitude signal and setting the band-rejection filter to suppress one or more peaks belonging to a pre-determined frequency band of the computed frequency spectrum.

A method according to an exemplifying and non-limiting embodiment of the invention comprises setting the band-rejection filter to form one or more transmission zeros at one or more frequencies corresponding to the one or more peaks of the computed frequency spectrum.

In a method according to an exemplifying and non-limiting embodiment of the invention, the voltage control loop comprises a low-pass filter.

A method according to an exemplifying and non-limiting embodiment of the invention further comprises controlling the excitation of the synchronous generator with the aid of one or more power system stabilizers "PSS". Each power system stabilizer uses information indicative of deviation of a measured rotational speed of the synchronous generator from the nominal rotational speed, deviation of a measured frequency of the voltage from the nominal frequency, or some other suitable information indicative of deviation from synchronous operation.

In a method according to an exemplifying and non-limiting embodiment of the invention, at least one of the power system stabilizers comprises a band-rejection filter having a stop-band covering at least partly the frequency area of the torsional mode oscillations of the rotating system.

In a method according to an exemplifying and non-limiting embodiment of the invention, a first one of the power system stabilizers increases the synchronizing torque of the synchronous generator and a second one of the power system stabilizers increases the braking torque of the synchronous generator.

In a method according to an exemplifying and non-limiting embodiment of the invention, the electrical power system is an electrical power system of a ship.

A computer program according to an exemplifying and non-limiting embodiment of the invention comprises computer executable instructions for configuring one or more programmable digital signal processing "DSP" circuits of a voltage regulator of an electrical power system to carry out actions related to a method according to any of the above-described exemplifying embodiments of the invention.

In the exemplifying and non-limiting embodiments described above with reference to figures 1a, 1b, 2-5, the frequency components related to the torsional mode oscillations are suppressed with the aid of a band-rejection filter. It is, however, also possible that the voltage control loop comprises some other signal conditioning device for suppressing the frequency components related to the torsional mode oscillations. These frequency components can be suppressed for example with a canceller device that is configured to form, with adaptive signal processing means, a cancelling signal and to add the cancelling signal to the signal under consideration so that the signal power on a desired frequency area related to the torsional mode oscillations is minimized.

## Claims

1.   A method for controlling an excitation of a synchronous generator, the method comprising:

   - producing (501) an amplitude signal indicative of amplitude of voltage of the synchronous generator, and
   - operating (502) a voltage control loop for controlling the excitation of the synchronous generator on the basis of the amplitude signal and reference amplitude of the voltage,

   **characterized in that** the voltage control loop comprises a band-rejection filter having a stop-band covering at least partly a frequency area of torsional mode oscillations of a rotating system comprising a rotor of the synchronous generator, wherein an input signal of the band-rejection filter comprises at least the amplitude signal.

2.   A method according to claim 1, wherein the method further comprises controlling the excitation of the synchronous generator with one or more power system stabilizers each comprising a lead-lag circuitry and using information indicative of deviation from synchronous operation.

3. A method according to claim 2, wherein at least one of the power system stabilizers comprises a band-rejection filter having a stop-band covering at least partly the frequency area of the torsional mode oscillations of the rotating system.

4. A voltage regulator (108, 208, 308, 408) for controlling an excitation of a synchronous generator, the voltage regulator comprising:

- a first signal interface (409) for receiving an amplitude signal indicative of amplitude of voltage of the synchronous generator,
- a second signal interface (410) for connecting to an excitation device connected to the synchronous generator, and
- a controller (103) for constituting a part of a voltage control loop for controlling the excitation of the synchronous generator on the basis of the amplitude signal and reference amplitude of the voltage,

**characterized in that** the voltage regulator comprises a band-rejection filter (104) for constituting another part of the voltage control loop, wherein an input signal of the band-rejection filter comprises at least the amplitude signal.

5. A voltage regulator according to claim 4, wherein a lower corner frequency of the stop-band of the band-rejection filter is on a range from 30 % to 70 % of $f_s/2p$ and an upper corner frequency of the stop-band of the band-rejection filter is on a range from 80 % to 150 % of the $f_s/2p$, $f_s$ being a nominal frequency of the voltage of the synchronous generator and p being a positive integer indicative of a number of pole pairs of the synchronous generator.

6. A voltage regulator according to claim 4 or 5, wherein the band-rejection filter comprises one or more controllable components for implementing a changeable frequency response.

7. A voltage regulator according to claim 6, wherein the voltage regulator further comprises a processing system (205) for computing a frequency spectrum of the amplitude signal and for setting the band-rejection filter to suppress one or more peaks belonging to a pre-determined frequency band of the frequency spectrum.

8. A voltage regulator according to claim 7, wherein:

- the one or more controllable elements of the band-rejection filter are suitable for forming one or more changeable transmission zeros on the frequency response of the band-rejection filter, and
- the processing system is configured to set the band-rejection filter to form the one or more changeable transmission zeros at one or more frequencies corresponding to the one or more peaks of the frequency spectrum.

9. A voltage regulator according to any of claims 4-8, wherein the voltage regulator further comprises a low-pass filter (206) for constituting a part of the voltage control loop.

10. A voltage regulator according to any of claims 4-9, wherein the voltage regulator further comprises one or more third signal interfaces (411) for receiving one or more stabilizer signals produced by one or more power system stabilizers, and the controller (103) is suitable for constituting a part of one or more stabilizing control loops each comprising one of the power system stabilizers.

11. An electrical power system comprising:

- at least one synchronous generator (101), a rotor of the synchronous generator being a part of a rotating system,
- a signal transducer (102) for producing an amplitude signal indicative of amplitude of voltage of the synchronous generator, and
- a controller (103) for controlling an excitation device connected to the synchronous generator,

wherein the signal transducer and the controller are parts of a voltage control loop for controlling an excitation of the synchronous generator on the basis of the amplitude signal and reference amplitude of the voltage, and the voltage control loop comprises a band-rejection filter (104, 304) having a stop-band covering at least partly a frequency area of torsional mode oscillations of the rotating system, wherein the electrical power system comprises a voltage regulator (108, 208, 308, 408) according to any of claims 4-10, and the controller and the band-rejection filter are parts of the voltage regulator.

12. An electrical power system according to claim 11, wherein:

- the electrical power system further comprises one or more power system stabilizers (207, 307) each comprising a lead-lag circuitry, and
- the controller (103) constitutes a part of one or more stabilizing control loops each comprising one of the power system stabilizers and being configured to control the excitation of the synchronous generator on the basis of information indicative of deviation from synchronous operation.

13. An electrical power system according to claim 12, wherein at least one of the power system stabilizers comprises a band-rejection filter (204) having a stop-band covering at least partly the frequency area of the torsional mode oscillations of the rotating system.

14. An electrical power system according to any of claims 11-13, wherein the electrical power system is an electrical power system of a ship.

15. A computer program comprising instructions which, when the computer program is executed by a computer, cause the computer to carry out the method of claim 1.

**Patentansprüche**

1. Verfahren zum Steuern einer Erregung eines Synchrongenerators, wobei das Verfahren Folgendes umfasst:

- Erzeugen (501) eines Amplitudensignals, das eine Spannungsamplitude des Synchrongenerators angibt, und
- Betreiben (502) eines Spannungsregelkreises zum Steuern der Erregung des Synchrongenerators auf der Grundlage eines Amplitudensignals und Referenzamplitude der Spannung,

**dadurch gekennzeichnet, dass** der Spannungsregelkreis ein Bandsperrfilter mit einem Sperrband aufweist, das mindestens teilweise einen Frequenzbereich von Torsionsschwingungen eines rotierenden Systems abdeckt, das einen Rotor des Synchrongenerators umfasst, wobei ein Eingangssignal des Bandsperrfilters mindestens das Amplitudensignal umfasst.

2. Verfahren nach Anspruch 1, wobei das Verfahren ferner das Steuern der Erregung des Synchrongenerators mit einem oder mehreren Energiesystemstabilisatoren umfasst, die jeweils eine Voreilungsschaltung umfassen und Informationen verwenden, die eine Abweichung vom Synchronbetrieb angeben.

3. Verfahren nach Anspruch 2, wobei mindestens einer der Energiesystemstabilisatoren ein Bandsperrfilter umfasst, das ein Sperrband aufweist, das den Frequenzbereich der Torsionsschwingungen des rotierenden Systems mindestens teilweise abdeckt.

4. Spannungsregler (108, 208, 308, 408) zum Steuern einer Erregung eines Synchrongenerators, wobei der Spannungsregler Folgendes umfasst:

- eine erste Signalschnittstelle (409) zum Empfangen eines Amplitudensignals, das eine Spannungsamplitude des Synchrongenerators angibt,
- eine zweite Signalschnittstelle (410) zum Verbinden mit einer Erregungsvorrichtung, die mit dem Synchrongenerator verbunden ist, und
- eine Steuervorrichtung (103) zum Bilden eines Teils eines Spannungsregelkreises zum Steuern der Erregung des Synchrongenerators auf der Grundlage des Amplitudensignals und Referenzamplitude der Spannung,

**dadurch gekennzeichnet, dass** der Spannungsregler ein Bandsperrfilter (104) zum Bilden eines anderen Teils des Spannungsregelkreises umfasst, wobei ein Eingangssignal des Bandsperrfilters mindestens das Amplitudensignal umfasst.

5. Spannungsregler nach Anspruch 4, wobei eine untere Eckfrequenz des Sperrbands des Bandsperrfilters in einem Bereich von 30 % bis 70 % von $f_s$/2p liegt, und eine obere Eckfrequenz des Sperrbandes des Bandsperrfilters in einem Bereich von 80 % bis 150 % von $f_s$/2p liegt, wobei $f_s$ eine Nennfrequenz der Spannung des Synchrongenerators ist und p eine positive Ganzzahl ist, die eine Anzahl von Polpaaren des Synchrongenerators angibt.

6.  Spannungsregler nach Anspruch 4 oder 5, wobei das Bandsperrfilter eine oder mehrere steuerbare Komponenten zum Umsetzen eines veränderbaren Frequenzgangs umfasst.

7.  Spannungsregler nach Anspruch 6, wobei der Spannungsregler ferner ein Verarbeitungssystem (205) zum Berechnen eines Frequenzspektrums des Amplitudensignals und zum Einstellen des Bandsperrfilters zum Unterdrücken einer oder mehrerer Spitzen, die zu einem vorbestimmten Frequenzband des Frequenzspektrums gehören, umfasst.

8.  Spannungsregler nach Anspruch 7, wobei:

    - das eine oder die mehreren steuerbaren Elemente des Bandsperrfilters zum Bilden einer oder mehrerer veränderbarer Transmissionsnullstellen in dem Frequenzgang des Bandsperrfilters geeignet sind, und
    - das Verarbeitungssystem dazu konfiguriert ist, das Bandsperrfilter einzustellen, um die eine oder die mehreren veränderbaren Transmissionsnullstellen bei einer oder mehreren Frequenzen zu bilden, die der einen oder mehreren Spitzen des Frequenzspektrums entsprechen.

9.  Spannungsregler nach einem der Ansprüche 4-8, wobei der Spannungsregler ferner ein Tiefpassfilter (206) zum Bilden eines Teils des Spannungsregelkreises umfasst.

10. Spannungsregler nach einem der Ansprüche 4-9, wobei der Spannungsregler ferner eine oder mehrere dritte Signalschnittstellen (411) zum Empfangen eines oder mehrerer Stabilisatorsignale umfasst, die von einem oder mehreren Energiesystemstabilisatoren erzeugt werden, und die Steuervorrichtung (103) dazu geeignet ist, einen Teil einer oder mehrerer stabilisierender Steuerkreise zu bilden, die jeweils einen der Energiesystemstabilisatoren umfassen.

11. Elektrisches Energiesystem, umfassend:

    - mindestens einen Synchrongenerator (101), wobei ein Rotor des Synchrongenerators ein Teil des rotierenden Systems ist,
    - einen Signal-Transducer (102) zum Erzeugen eines Amplitudensignals, das eine Spannungsamplitude des Synchrongenerators angibt, und
    - eine Steuervorrichtung (103) zu Steuern einer Erregungsvorrichtung, die mit dem Synchrongenerator verbunden ist,

    wobei der Signal-Transducer und die Steuervorrichtung Teile eines Spannungsregelkreises zum Steuern einer Erregung des Synchrongenerators auf der Grundlage des Amplitudensignals und der Referenzamplitude der Spannungen sind, und der Spannungsregelkreis ein Bandsperrfilter (104, 304) umfasst, das ein Sperrband aufweist, das mindestens teilweise einen Frequenzbereich von Torsionsschwingungen des rotierenden Systems abdeckt, wobei das elektrische Energiesystem einen Spannungsregler (108, 208, 308, 408) nach einem der Ansprüche 4-10 umfasst, und die Steuervorrichtung und das Bandsperrfilter Teile des Spannungsregler sind.

12. Elektrisches Energiesystem nach Anspruch 11, wobei:

    - das elektrische Energiesystem ferner einen oder mehrere Energiesystemstabilisatoren (207, 307) umfasst, die jeweils eine Voreilungsschaltung umfassen, und
    - die Steuervorrichtung (103) einen Teil eines oder mehrerer stabilisierender Steuerkreise bildet, die jeweils einen der Energiesystemstabilisatoren umfassen und dazu konfiguriert sind, die Erregung des Synchrongenerators auf der Grundlage von Informationen zu steuern, die eine Abweichung vom Synchronbetrieb angeben.

13. Elektrisches Energiesystem nach Anspruch 12, wobei mindestens einer der Energiesystemstabilisatoren ein Bandsperrfilter (204) umfasst, das ein Sperrband aufweist, das mindestens teilweise den Frequenzbereich der Torsionsschwingungen des rotierenden Systems abdeckt.

14. Elektrisches Energiesystem nach einem der Ansprüche 11-13, wobei das elektrische Energiesystem ein elektrisches Energiesystem eines Schiffs ist.

**15.** Computerprogramm, das Anweisungen umfasst, die, wenn das Computerprogramm von einem Computer ausgeführt wird, den Computer veranlassen, das Verfahren nach Anspruch 1 durchzuführen.

**Revendications**

**1.** Procédé pour commander une excitation d'un générateur synchrone, le procédé comprenant de :

- produire (501) un signal d'amplitude indicatif de l'amplitude de la tension du générateur synchrone, et
- faire fonctionner (502) une boucle de commande de tension pour commander l'excitation du générateur synchrone sur la base du signal d'amplitude et de l'amplitude de référence de la tension,

**caractérisé en ce que** la boucle de commande de tension comprend un filtre réjecteur de bande ayant une bande d'arrêt couvrant au moins en partie une zone de fréquence d'oscillations en mode torsion d'un système rotatif comprenant un rotor du générateur synchrone, dans lequel un signal d'entrée du filtre réjecteur de bande comprend au moins le signal d'amplitude.

**2.** Procédé selon la revendication 1, dans lequel le procédé comprend en outre de commander l'excitation du générateur synchrone avec un ou plusieurs stabilisateurs de système électrique comprenant chacun un circuit d'avance-retard et utilisant des informations indiquant un écart par rapport au fonctionnement synchrone.

**3.** Procédé selon la revendication 2, dans lequel au moins un des stabilisateurs du système électrique comprend un filtre réjecteur de bande ayant une bande d'arrêt couvrant au moins en partie la zone de fréquence des oscillations en mode torsion du système rotatif.

**4.** Régulateur de tension (108, 208, 308, 408) pour commander une excitation d'un générateur synchrone, le régulateur de tension comprenant :

- une première interface de signal (409) pour recevoir un signal d'amplitude indicatif de l'amplitude de tension du générateur synchrone,
- une deuxième interface de signal (410) pour se connecter à un dispositif d'excitation connecté au générateur synchrone, et
- un contrôleur (103) pour constituer une partie d'une boucle de commande de tension pour commander l'excitation du générateur synchrone sur la base du signal d'amplitude et de l'amplitude de référence de la tension,

**caractérisé en ce que** le régulateur de tension comprend un filtre réjecteur de bande (104) pour constituer une autre partie de la boucle de commande de tension, dans lequel un signal d'entrée du filtre réjecteur de bande comprend au moins le signal d'amplitude.

**5.** Régulateur de tension selon la revendication 4, dans lequel une fréquence de coin inférieure de la bande d'arrêt du filtre réjecteur de bande est comprise dans une plage allant de 30 % à 70 % de $f_s/2p$ et une fréquence de coin supérieure de la bande d'arrêt du filtre réjecteur de bande est comprise dans une plage de 80 % à 150 % de $f_s/2p$, $f_s$ étant une fréquence nominale de la tension du générateur synchrone et p étant un nombre entier positif indicatif d'un nombre de paires de pôles du générateur synchrone.

**6.** Régulateur de tension selon la revendication 4 ou 5, dans lequel le filtre réjecteur de bande comprend un ou plusieurs composants contrôlables pour mettre en œuvre une réponse de fréquence variable.

**7.** Régulateur de tension selon la revendication 6, dans lequel le régulateur de tension comprend en outre un système de traitement (205) pour calculer un spectre de fréquence du signal d'amplitude et pour régler le filtre réjecteur de bande pour supprimer un ou plusieurs pics appartenant à un pré- bande de fréquence déterminée du spectre de fréquences.

**8.** Régulateur de tension selon la revendication 7, dans lequel :

- le ou les éléments contrôlables du filtre réjecteur de bande sont adaptés pour former un ou plusieurs zéros de transmission variables sur la réponse de fréquence du filtre réjecteur de bande, et
- le système de traitement est configuré pour régler le filtre réjecteur de bande pour former les un ou plusieurs zéros de transmission variables à une ou plusieurs fréquences correspondant au ou aux pics du spectre de fréquence.

9. Régulateur de tension selon une quelconque des revendications 4 à 8, dans lequel le régulateur de tension comprend en outre un filtre passe-bas (206) pour constituer une partie de la boucle de commande de tension.

10. Régulateur de tension selon une quelconque des revendications 4 à 9, dans lequel le régulateur de tension comprend en outre une ou plusieurs troisièmes interfaces de signal (411) pour recevoir un ou plusieurs signaux de stabilisateur produits par un ou plusieurs stabilisateurs de système électrique et le contrôleur (103) est adapté pour constituer une partie d'une ou plusieurs boucles de commande de stabilisation comprenant chacune un des stabilisateurs du système électrique.

11. Système d'alimentation électrique comprenant :

    - au moins un générateur synchrone (101), un rotor du générateur synchrone faisant partie d'un système rotatif
    - un transducteur de signal (102) pour produire un signal d'amplitude indicatif de l'amplitude de tension du générateur synchrone, et
    - un contrôleur (103) pour commander un dispositif d'excitation connecté au générateur synchrone,

    dans lequel le transducteur de signal et le contrôleur font partie d'une boucle de commande de tension pour commander une excitation du générateur synchrone sur la base du signal d'amplitude et de l'amplitude de référence de la tension et la boucle de commande de tension comprend un filtre réjecteur de bande (104, 304) ayant une bande d'arrêt couvrant au moins en partie une zone de fréquence d'oscillations en mode torsion du système rotatif, dans lequel le système d'alimentation électrique comprend un régulateur de tension (108, 208, 308, 408) selon une quelconque des revendications 4 à 10 et le contrôleur et le filtre réjecteur de bande font partie du régulateur de tension.

12. Système d'alimentation électrique selon la revendication 11, dans lequel :

    - le système d'alimentation électrique comprend en outre un ou plusieurs stabilisateurs de système d'alimentation (207, 307) comprenant chacun un circuit d'avance-retard, et
    - le contrôleur (103) constitue une partie d'une ou plusieurs boucles de commande de stabilisation comprenant chacune un des stabilisateurs du système électrique et étant configuré pour commander l'excitation du générateur synchrone sur la base d'informations indiquant un écart par rapport au fonctionnement synchrone.

13. Système d'alimentation électrique selon la revendication 12, dans lequel au moins un des stabilisateurs du système d'alimentation comprend un filtre réjecteur de bande (204) ayant une bande d'arrêt couvrant au moins en partie la zone de fréquence des oscillations en mode torsion du système rotatif.

14. Système d'alimentation électrique selon une quelconque des revendications 1 à 13, dans lequel le système d'alimentation électrique est un système d'alimentation électrique d'un navire.

15. Programme informatique comprenant des instructions qui, lorsque le programme informatique est exécuté par un ordinateur, amènent l'ordinateur à exécuter le procédé selon la revendication 1.

**Figure 1a**

**Figure 1b**

**Figure 2**

**Figure 3**

**Figure 4**

START

501

Produce an amplitude signal indicative of the amplitude of voltage of a synchronous generator.

502

operate a voltage control loop comprising a band-rejection filter having a stop-band covering at least partly a frequency area of torsional mode oscillations of a rotating system comprising the rotor of the synchronous generator.

Figure 5

**EP 3 347 980 B1**

**REFERENCES CITED IN THE DESCRIPTION**

**Patent documents cited in the description**

- US 4080559 A
- US 4788653 A
- DE 102008043203
- US 4733156 A